# EUROPEAN PATENT SPECIFICATION

(11) **EP 2 328 160 B1**
(45) Date of publication and mention of the grant of the patent: **28.02.2018**
(21) Application number: 10191932.2
(22) Date of filing: 19.11.2010
(51) Int. Cl.: H01H 1/00, H01H 59/00

(54) **Switch structures**
Schaltstrukturen
Structures de commutation

(30) Priority: 30.11.2009 US 627476
(43) Date of publication of application: 01.06.2011
(73) Proprietor: General Electric Company, Schenectady, NY 12345 (US)
(72) Inventor: Aimi, Marco Francesco, Niskayuna, NY 12309 (US); Bansal, Shubhra, Niskayuna, NY 12309 (US); Keimel, Christopher Fred, Niskayuna, NY 12309 (US); Kishore, Kuna Venkat Satya Rama, Niskayuna, NY 12309 (US); Sundaram, Sairam, Niskayuna, NY 12309 (US); Thakre, Parag, Niskayuna, NY 12309 (US)
(74) Representative: Illingworth-Law, William Illingworth

(56) References cited:
- EP-A1- 2 073 236
- US-A- 4 959 515
- US-A1- 2007 222 004
- US-A1- 2008 087 530
- SLAVCHEVA E ET AL: "Electrodeposition and properties of NiW films for MEMS application", ELECTROCHIMICA ACTA, ELSEVIER SCIENCE PUBLISHERS, BARKING, GB, vol. 50, no. 28, 30 September 2005 (2005-09-30), pages 5573-5580, XP027694426, ISSN: 0013-4686 [retrieved on 2005-09-30]

## Description

### BACKGROUND

Embodiments of the invention relate generally to devices for switching current, and more particularly to microelectromechanical switch structures.

A circuit breaker is an electrical device designed to protect electrical equipment from damage caused by faults in the circuit. Traditionally, many conventional circuit breakers include bulky (macro-)electromechanical switches. Unfortunately, these conventional circuit breakers are large in size and may necessitate use of a large force to activate the switching mechanism. Additionally, the switches of these circuit breakers generally operate at relatively slow speeds. Furthermore, these circuit breakers can be complex to build and thus expensive to fabricate. In addition, when contacts of the switching mechanism in conventional circuit breakers are physically separated, an arc can sometimes form therebetween, which arc allows current to continue to flow through the switch until the current in the circuit ceases. Moreover, energy associated with the arc may seriously damage the contacts and/or present a burn hazard to personnel.

As an alternative to slow electromechanical switches, relatively fast solid-state switches have been employed in high speed switching applications. These solid-state switches switch between a conducting state and a non-conducting state through controlled application of a voltage or bias. However, since solid-state switches do not create a physical gap between contacts when they are switched into a non-conducting state, they experience leakage current when nominally non-conducting. Furthermore, solid-state switches operating in a conducting state experience a voltage drop due to internal resistances. Both the voltage drop and leakage current contribute to power dissipation and the generation of excess heat under normal operating circumstances, which may be detrimental to switch performance and life. Moreover, due at least in part to the inherent leakage current associated with solid-state switches, their use in circuit breaker applications is not possible.

Micro-electromechanical system (MEMS) based switching devices may provide a useful alternative to the macro-electromechanical switches and solid-state switches described above for certain current switching applications. MEMS-based switches tend to have a low resistance when set to conduct current, and low (or no) leakage when set to interrupt the flow of current therethrough. Further, MEMS-based switches are expected to exhibit faster response times than macro-electromechanical switches. Examples of MEMS based switches and shunts can be found in EP 2073236 and US 4959515 respectively.

### BRIEF DESCRIPTION

The present invention is defined in the accompanying claims.

In one aspect, a device, such as a switch structure, is provided. The switch structure includes a contact and a conductive element each respectively disposed on a substrate. The conductive element is composed substantially of metallic material, and is configured to be deformable between a first position, in which the conductive element is separated from the contact by a separation distance, and a second position, in which the conductive element contacts (and, in some cases, establishes electrical communication with) the contact and stores mechanical energy (*e.g*., mechanical energy sufficient to cause the conductive element to substantially assume the first position in the absence of external forces). For example, the conductive element can include a cantilever, a fixed-fixed beam, a torsional element, and/or a diaphragm. The switch structure may include an electrode disposed on the substrate and configured to be charged so as to apply an electrostatic force configured to urge the conductive element toward the second position.

The conductive element is configured such that, subsequent to being deformed into the second position at a temperature between about room temperature and about half of a melting temperature of the metallic material for a cumulative time of at least 10⁷ seconds, the separation distance in the absence of external forces varies by less than 20 percent over the cumulative time. The conductive element includes an anchor extending from the substrate and a beam having an end coupled to the anchor so as to be cantilevered therefrom. The beam and the anchor can define therebetween an angle, and the conductive element can be configured such that, subsequent to being deformed into the second position at a temperature between about room temperature and about half of a melting temperature of the metallic material for a cumulative time of at least 10⁷ seconds, the angle in the absence of external forces varies by less than 0.1 percent. Additionally, or alternatively, the conductive element can be configured such that, when the conductive element is deformed into the second position at a temperature between about room temperature and about half of a melting temperature of the metallic material, a maximum, non-localized, steady-state strain rate in the anchor remains less than about 10⁻¹² s⁻¹. In some cases, the conductive element can be configured such that an initial deformation of the conductive element into the second position induces a first elastic strain in the anchor and, subsequent to being deformed into the second position at a temperature between about room temperature and about half of a melting temperature of the metallic material for a cumulative time of at least 10⁷ seconds, the anchor experiences a maximum, non-local total plastic strain of less than about half of the first elastic strain.

The metallic material includes an alloy of at least 65 atomic percent nickel and at least 1 atomic percent tungsten, and the conductive element can be configured such that, when the conductive element is deformed between the first and second positions, a stress in the anchor is less than 1000 MPa.

In some embodiments, the beam can have a length that is less than about 200 times greater than a thickness of the beam and is also less than about 1000 times the separation distance. Further, the contact can be disposed so as to oppose the conductive element over an area defined by an overlap length that is within 20 percent of a free end of the cantilevered beam. The contact and conductive element may be part of a microelectromechanical device or a nanoelectromechanical device, and the conductive element may have a surface area-to-volume ratio that is greater than or equal to 10³ m⁻¹.

The contact and conductive element can be respectively connected to first and second sides of a circuit, which first and second sides are at different electric potentials. Deformation of the conductive element between the first and second positions may acts to respectively pass and interrupt a current therethrough. The first side can include a power source configured to supply a current of at least 1 mA that oscillates at a frequency less than or equal to about 1 kHz.

In another aspect, a method is provided that includes providing a substrate, forming a contact on the substrate, and forming a conductive element (say, having a surface area-to-volume ratio that is greater than or equal to 10³ m⁻¹) substantially of metallic material on the substrate. The conductive element includes an anchor extending from the substrate and a beam having an end coupled to the anchor so as to be cantilevered therefrom, the anchor and beam defining an angle therebetween. The conductive element can be deformed, at a temperature between about room temperature and about half of a melting temperature of the metallic material, between a first position, in which the conductive element is separated from the contact by a separation distance, and a second position, in which the conductive element contacts the contact and stores energy, with the conductive element occupying the second position for a cumulative time of at least 10⁷ seconds. Subsequent to the deforming the conductive element, external forces can be removed from the conductive element, such that the conductive element returns to the first position, with the angle varies by less than 0.1 percent. In some embodiments, an electrode can be formed on the substrate, the electrode being configured to establish an electrostatic force configured to urge the conductive element toward the second position. Also, the contact and conductive element can be enclosed between the substrate and a protective cap.

The contact and conductive element can be respectively connected to opposing sides of a circuit, the opposing sides being at different electric potentials when the opposing sides are disconnected. The conductive element can be selectively deformed between the first and second positions so as to respectively pass and interrupt a current therethrough.

### DRAWINGS

These and other features, aspects, and advantages of the present invention will become better understood when the following detailed description is read with reference to the accompanying drawings in which like characters represent like parts throughout the drawings, wherein:
Fig. 1 is a schematic perspective view of a switch structure configured in accordance with an example, which is not an embodiment of the present invention.
Fig. 2 is a schematic side view of the switch structure of Fig. 1;
Fig. 3 is a schematic fragmentary perspective view of the switch structure of Fig. 1;
Fig. 4 is a schematic side view of the switch structure of Fig. 1 in an open position;
Fig. 5 is a schematic side view of the switch structure of Fig. 1 in a closed position;
Figs. 6A-C are side views of the switch structure of Fig. 1 demonstrating the movement of the beam between the contacting and non-contacting positions;
Fig. 7 is a schematic side view of a switch structure configured in accordance with another example which is not an embodiment of the present invention.
Fig. 8 is a schematic side view of the switch structure of Fig. 7;
Fig. 9 is a schematic fragmentary perspective view of the switch structure of Fig. 7;
Figs. 10A-E are schematic side views representing a process for fabricating a switch structure configured in accordance with the examples.
Fig. 11 is a schematic perspective view of a switch structure configured in accordance with another example which is an embodiment of the present invention.
Fig. 12 is a schematic side view of the switch structure of Fig. 11;
Fig. 13 is a schematic fragmentary perspective view of the switch structure of Fig. 11;
Fig. 14 is a schematic perspective view of a switch structure configured in accordance with yet another example which is not an embodiment of the present invention.
Fig. 15 is a schematic side view of the switch structure of Fig. 14;
Fig. 16 is a schematic fragmentary perspective view of the switch structure of Fig. 14;
Fig. 17 is a schematic perspective view of a switch structure configured in accordance with still another example, which is also an embodiment of the present invention; and
Fig. 18 is a schematic side view of a switch structure configured in accordance with yet another example embodiment.

### DETAILED DESCRIPTION

Examples, some of which are embodiments of the present invention, are described below in detail with reference to the accompanying drawings, where the same reference numerals denote the same parts throughout the drawings. Some of these embodiments may address the above and other needs.

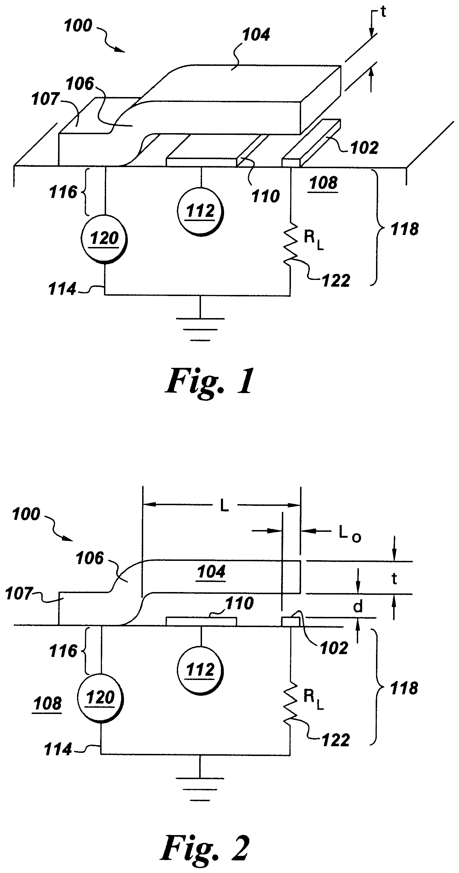

Referring to Figs. 1-3, therein are shown several schematic views of a switch structure **100** configured in accordance with an example, which is not an embodiment of the present invention. The switch structure **100** can include a contact **102,** which may be, for example, a pad formed, at least partially, of a conductive material (*e.g*., metal). The switch structure **100** can also include a conductive element, such as a cantilevered beam **104,** formed substantially of conductive material (*e.g*., metal). In some examples, the conductive element may also include other features, such as, for example, a protective (and possibly non-conductive) coating on the beam **104** and/or a contact pad, say, disposed over a portion of the beam intended to contact the contact **102** (discussed further below). The beam **104** can be supported by an anchor **106** and a base **107,** which may be integrated with the beam and may serve to connect the beam to an underlying support structure, such as a substrate **108.** The contact **102** may also be supported by the substrate **108.**

Disposing the contact **102** and beam **104** on a substrate **108** may facilitate the production of the switch structure **100** through conventional microfabrication techniques (*e.g*., electroplating, vapor deposition, photolithography, wet and/or dry etching, etc.). Along these lines, the switch structure **100** may constitute a portion of a microelectromechanical or nanoelectromechanical device or a microelectromechanical system (MEMS). For example, the contact **102** and beam **104** may have dimensions on the order of ones or tens of micrometers and/or nanometers. In one example, the beam **104** may have a surface area-to-volume ratio that is greater than or equal to 10⁸ m⁻¹, while in another embodiment the ratio may be closer to 10³ m⁻¹. Details regarding possible methods for fabricating the switch structure **100** are discussed further below.

The substrate **108** may also include or support conventional semiconductor devices and/or components, such as, for example, metal-oxide-semiconductor field effect transistors (MOSFETs) and patterned conductive layers (not shown) that serve to provide electrical connections thereto and therebetween. Such patterned conductive layers may also provide electrical connections to the contact **102** and beam **104** (the connection to the latter being, for example, through the anchor **106** and base **107**), which connections are shown schematically in Figs. 1 and 2 and described below. The semiconductor devices and conductive layers, like the features of the switch structure **100,** can be fabricated using conventional microfabrication techniques. In one example, the substrate **108** may be a semiconductor wafer that has been processed so as to include one or more MOSFETs, with the switch structure **100** and other circuitry formed on a surface of the wafer. The switch structure **100** may be disposed over one of the MOSFETs (*e.g*., a line normal to the surface of the wafer would intersect both the MOSFET and the switch structure) and may be operable along with the MOSFET (discussed further below). In other examples, the substrate **108** may be formed of materials other than semiconductor wafers, including, for example, diamond, sapphire, quartz, polyimide, insulated metal substrates, etc.

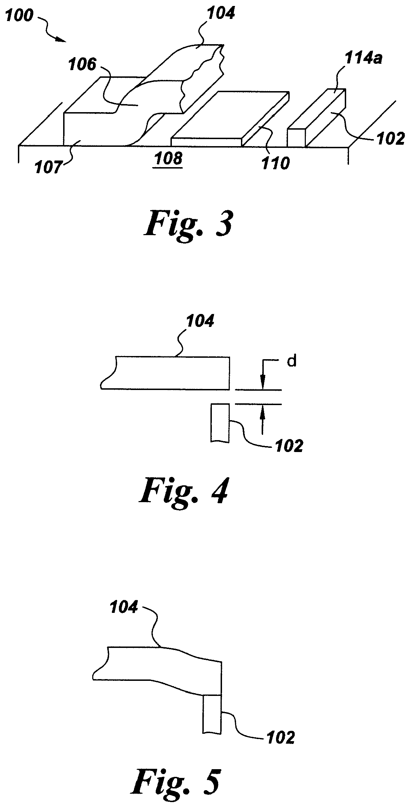

Referring to Figs. 1-5. the beam **104** can be configured to be selectively moveable between a first, non-contacting or "open" position (*e.g.*, Fig. 4), in which the beam is separated from the contact **102** by a separation distance *d*, and a second, contacting or "closed" position (*e.g*., Fig. 5), in which the beam comes into contact and establishes electrical communication with the contact. For example, the beam **104** can be configured to undergo deformation when moving between the contacting and non-contacting positions, such that the beam is naturally disposed (*i.e.*, in the absence of externally applied forces) in the non-contacting position and may be deformed so as to occupy the contacting position while storing mechanical energy therein. In other embodiments, the undeformed configuration of the beam 104 may be the contacting position.

The switch structure **100** may also include an electrode **110.** When the electrode **110** is appropriately charged, such that a potential difference exists between the electrode and the beam **104,** an electrostatic force will act to pull the beam towards the electrode (and also toward the contact **102**). By appropriately choosing the voltage to be applied to the electrode **110,** the beam **104** can be deformed by the resulting electrostatic force sufficiently to move the beam from the non-contacting (*i.e.*, open or non-conducting) position to the contacting (*i.e.*, closed or conducting) position. Therefore, the electrode **110** may act as a "gate" with respect to the switch structure **100,** with voltages (referred to as "gate voltages") applied to the electrode serving to control the opening/closing of the switch structure. The electrode **110** may be in communication with a gate voltage source **112,** which gate voltage source may apply a selective gate voltage *V_{G}* to the electrode.

The contact **102** and beam **104** may act as part of a circuit **114.** For example, the circuit **114** can have a first side **116** and a second side **118** that, when disconnected from one another, are at different electric potentials relative to one another (as where only one of the sides is connected to a power source **120**). The contact **102** and beam **104** can be respectively connected to either of the sides **116, 118** of the circuit **114,** such that deformation of the beam between the first and second positions acts to respectively pass and interrupt a current therethrough. The beam **104** may be repeatedly moved into and out of contact with the contact **102** at a frequency (either uniform or non-uniform) that is determined by the application within which the switch structure **100** is utilized. When the contact **102** and the beam **104** are separated from one another, a potential difference, and voltage difference, would exist between the contact and beam, and this voltage difference is referred to as the "stand-off voltage."

In one example, the beam **104** may be in communication (*e.g*., via the anchor **106** and base **107**) with the power source **120,** and the contact **102** may be in communication with an electrical load **122** presenting, say, a load resistance *R_{L}*. The power source **120** may be operated at different times as a voltage source and a current source. As such, the beam **104** may act as an electrical switch, allowing a load current (say, with an amplitude greater than or equal to about 1 mA and an oscillation frequency of less than or equal to about 1 kHz) to flow from the power source **120** through the beam and the contact **102** and to the electrical load **122** when the beam is in the contacting position, and otherwise disrupting the electrical path and preventing the flow of current from the power source to the load when the beam is in the non-contacting position. The above-indicated current and switching frequency might be utilized in relatively higher power distribution applications. In other examples, such as in applications where the switch structure **100** will be utilized in a signaling context (often operating at relatively lower powers), the power source **120** may provide a current having a magnitude of 100 mA or less (and down to the 1 µA range) with a frequency of oscillation greater than 1 kHz.

The above-described switch structure **100** could be utilized as part of a circuit including other switch structures, whether similar or dissimilar in design, in order to increase the current and voltage capacity of the overall circuit. For example, the switch structures could be arrayed both in series and in parallel in order to facilitate a desired distribution of stand-off voltage when the switch structures are open (*e.g.*, a relatively even distribution of voltage between the switch structures) and a desired distribution of current when the switch structures are closed (*e.g*., a relatively even distribution of current between the switch structures).

During operation of the switch structure **100,** the beam **104** may be subjected to externally applied forces, such as the electrostatic force established by the electrode **110** discussed above, that cause the beam to deform between the first and second positions (*i.e*., into and out of contact with the contact **102**). These forces may be applied, and the switch structure **100** may operate, at ambient temperatures (use temperatures) from room temperature up, but often less than 50 percent or even 30 percent of the melting temperature of the material(s) from which the beam is substantially formed. Further, for applications in which the switch structure **100** is expected to possess a useful lifetime on the order of years (*e.g*., relatively higher power distribution applications), the beam 104 may remain in contact with the contact **102** for a cumulative time of at least 10⁴ seconds, and in some cases for more than 10⁶ seconds or even 10⁸ seconds. Still further, when deformed so as to contact the contact **102,** the beam **104** may experience relatively high stresses, the magnitude of the stresses depending on the geometry of the switch structure **100** and the material from which the beam is substantially formed.

As one example of the above, the switch structure **100** can include a cantilevered beam **104** of nickel (Ni)-12 atomic percent tungsten (W) with a length *L* of about 100 µm, an aspect ratio (length *L* to thickness *t*) of about 25 to 1, and a separation distance *d* from the contact **102** of about 1-3 µm, where the contact is located opposite the free end of the beam and overlaps the beam by a distance *L₀.* For such geometry, a stress of more than 100 MPa, and as much as 600 MPa or more, may be present in substantial portions of the beam **104** and/or anchor **106** when the beam is deformed so as to contact the contact **102.** As mentioned earlier, in some applications, the beam **104** and/or anchor **106** may be required to sustain this stress for a time that may be as long or longer than 10⁴ seconds, or even 10⁸ seconds, under use conditions, without failure. These stresses are expected to be separate from the highly localized, and often transient, stresses that may be present around stress concentration regions, such as around geometrical irregularities, surface asperities, and defects.

For proper operation of a switch structure (such as the switch structure **100**) including a cantilevered beam (or other deformable contacting structure) and associated contact, it is often intended that the beam assume either the contacting position or the non-contacting position as specified by the presence or absence of an external force urging the beam into contact with the contact (*e.g.*, the presence or absence of the gate voltage associated with the electrode **110** and the corresponding electrostatic force). However, a variety of investigators have observed that switch structures including a metallic, micrometer-scale cantilevered beam (or other deformable contacting structure) tend to malfunction, such that the behavior of the switch structure is not as intended. These malfunctions are generally attributed to surface adhesion-related issues. Specifically, in light of the large surface area-to-volume ratio present in a micrometer-scale beam (or other deformable contacting structure), the energy reduction associated with the elimination of free surface where the beam contacts the associated contact pad may be non-trivial or even higher relative to the mechanical energy stored in the beam during deformation. As such, theory has it, the cantilevered beam and associated contact remain adhered following the removal of the external force otherwise urging the two into contact, as the internal strain energy of the beam is insufficient to induce separation of the beam from the contact.

In contrast to the prevailing theories, the applicants have observed that failure of switch structures including metallic, small-scale cantilevered beams is often due not to adhesion of the beam and an associated contact, but mainly to a change in the undeformed configuration of the beam. That is, as an external force is applied to urge the beam into contact with the associated contact, the beam undergoes time-dependent plastic deformation, also referred to as "creep."

As the beam undergoes time-dependent plastic deformation, the undeformed configuration of the beam (*i.e.*, the shape the beam assumes in the absence of an external load) moves from that with the beam disposed in the non-contacting position towards a configuration in which the beam is disposed in the contacting position. Similarly, the mechanical strain energy initially associated with the beam when in the contacting position is reduced, in some cases to nearly zero. Ultimately, the switch structure may fail due to adhesion between the beam and the associated contact, but this failure mechanism may be secondary, and due, to the reduction in the mechanical strain energy associated with the beam in the contacting position. The time-dependent plastic deformation of the beams associated with switch structures is surprising, in that these devices are often operating at ambient temperatures under 50 percent or even 30 percent of the melting temperature of the metallic material from which the beam is formed (or, if the beam is formed of multiple discrete metallic materials, temperatures under 50 percent or even 30 percent of the minimum melting temperature associated with one of the metals constituting a substantial part of the beam).

In view of the applicants' discovery, the beam **104** may be configured so as to limit, under use conditions including temperatures under 50 percent or even 30 percent of the minimum melting temperature associated with one of the metals constituting a substantial part of the beam, permanent deformation of the beam due to time-dependent plastic deformation of the metallic material from which the beam is substantially formed. It is noted that the beam **104** can be considered to be "formed substantially" of metallic material when the mechanical behavior of the beam is generally or significantly determined by the mechanical behavior of constituent metallic material. During operation of the switch structure **100,** the beam **104** can at times be disposed in the first (non-contacting) position, in which the beam is separated from the contact **102** by a separation distance *d.* At other times, the beam **104** can be disposed in the second (contacting) position, in which the beam comes into contact the contact **102.** The beam **104** may be deformed into the second (closed) for a cumulative time of at least 10⁷ seconds and at a temperature between room temperature and about half of the melting temperature of the metallic material (or, where the metallic material includes multiple discrete metallic materials, the melting temperature of one of the metallic materials from which the beam is substantially formed). The beam **104** may be geometrically configured such that, subsequent to such deformation, the separation distance *d* between the beam **104** and the contact **102,** in the absence of external forces, varies by less than 20 percent over the cumulative time (that is, measurements of *d* taken at any time over the cumulative time would yield a result that is within 20 percent of one another).

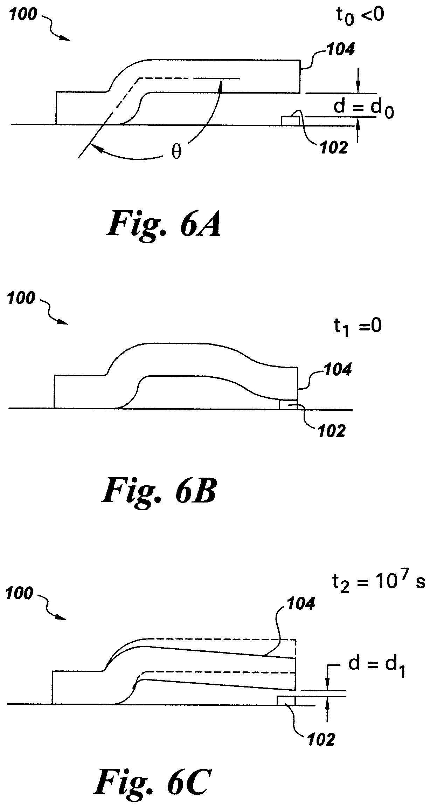

For example, referring to Figs. 6A-C, at time *t₀* < 0, the beam **104** can be disposed in the first (non-contacting) position, in which the beam is separated from the contact **102** by a separation distance *d* = *d₀.* A force *F* can then be applied to the beam **104** at time *t₁* = 0 in order to deform the beam into the second (contacting) position, such that the beam comes into contact the contact **102.** The beam **104** can then be maintained in the second position until a time *t₂* = 10⁷ seconds, at which point the force *F* can be removed. As the force *F* is removed, the beam **104** can resume the first position, being separated from the contact **102** by a separation distance *d* = *d₁.*

Where the stresses experienced by the beam **104** are less than the stress necessary to cause plastic deformation of the metallic material from which the beam is substantially formed, and where the beam is completely free from the effects of time-dependent plastic deformation, *d₀* = *d₁.* Similarly, it is expected that the magnitude of the force *F* that is required to maintain the beam **104** in the second position, and the amount of mechanical energy stored in the beam when disposed in the second position, would remain constant. However, due to time-dependent plastic deformation, Applicants have found that *d₁* is often less than *d₀.* Still, the beam **104** can be configured so as to assure that the separation distance *d* between the contact **102** and the beam is sufficient to allow the switch structure **100** to function properly.

For example, the beam **104** can be configured so as to assure that *d₀* ≥ *d₁* ≥ 0.8*d₀.* Additionally, or alternatively, the beam **104** can be configured to store energy during deformation sufficient to cause the beam to substantially assume the first position (*e.g*., within 20 percent) in the absence of external forces. Further, the beam **104** and the anchor **107** may define an angle *θ* therebetween, and the beam **104** can be configured such that the angle *θ*, in the absence of external forces acting on the beam, varies by less than 0.5 percent, and in some cases less than 0.1 percent, as a result of the beam being deformed between the first and second positions.

The applicants have further discovered that, for switch structures including a cantilevered beam, for example, as shown in Fig. 1, time dependent plastic deformation in the anchor of the beam (or the structure from which the beam is otherwise cantilevered) can be a significant cause for a permanent change of configuration of the overall beam. As such, the beam **104** can be configured such that, when the beam is deformed into the second position, a maximum, non-localized, steady-state strain rate in the anchor remains less than about 10⁻¹² s⁻¹. Alternatively, or additionally, the beam **104** can be configured such that the total plastic strain experienced by the anchor **106** remains less than some percentage of the elastic strain induced in the anchor upon initial deformation of the beam into the contacting position (prior to any significant creep in the beam). For example, if an initial deformation of the beam **104** into the second position induces a first elastic strain in the anchor **106,** and thereafter the beam is deformed into the second position for a cumulative time of at least 10⁷ seconds, the beam can be configured such that the anchor experiences a maximum, non-local total plastic strain of less than about half of the first elastic strain.

The beam **104** can be designed so as to limit the stress realized in the anchor **106** during deformation of the beam to below a threshold above which excessive plastic deformation would be realized. This threshold stress would depend on one or more of the temperature at which the beam **104** is deformed, the amount of shape change of the beam that can be tolerated within an application, and the material(s) from which the beam is substantially formed (including both the composition and the microstructure of the material(s)).

For example, for applications in which the switch structure **100** operates at a temperature less than about half the melting temperature of the material(s) from which the beam **104** is substantially formed, the applicants have found that acceptable performance (*e.g.*, a change in the separation distance between the beam and contact of less than 20 percent over a cumulative time of deformation of 10⁷ seconds or even up to 10⁸ seconds) can be achieved when the stress in a non-localized portion of the anchor (*i.e.*, away from a highly localized stress concentration region) is less than 1000 MPa for a beam for which the constituent metallic material includes an alloy of at least 65 atomic percent nickel and at least 1 atomic percent tungsten. As another example, the applicants have found that acceptable performance over time spans of one and 20 years can be achieved when the stress in a non-localized portion of the anchor (*i.e.*, away from a highly localized stress concentration region) is less than 45 and 20 MPa, respectively, for a beam for which the constituent metallic material includes 80 atomic percent gold and 20 atomic percent nickel. The applicants have also found that, for beams formed of pure gold, acceptable performance over a time span of one year can be achieved when the stress in a non-localized portion of the anchor is less than 25 MPa.

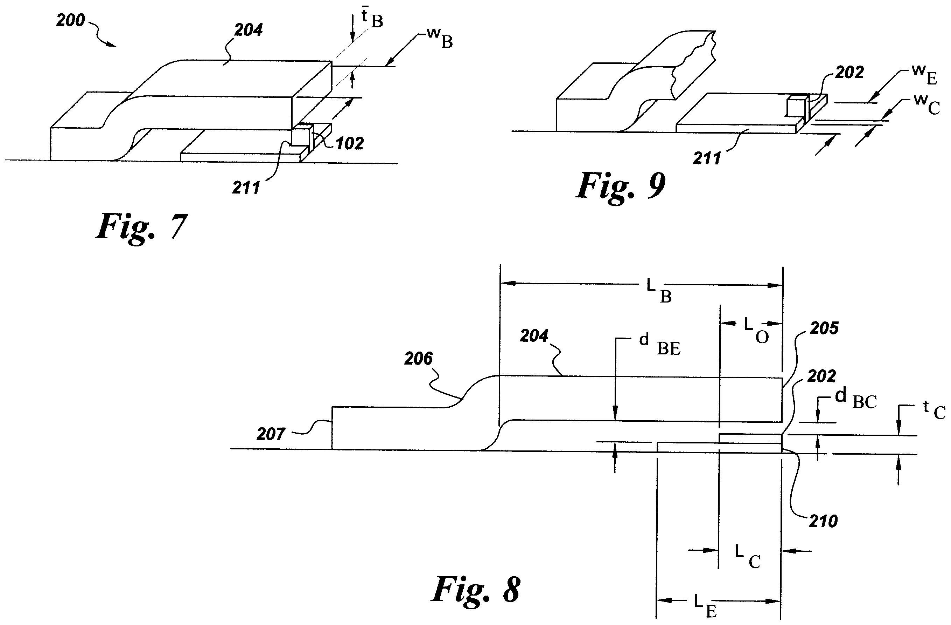

Overall, the beam **104** can be designed so as to limit stresses and/or plastic strains in the anchor **106.** For example, referring to Figs. 7-9, a switch structure **200** can include a contact **202** and a conductive element, such as a cantilevered beam **204,** formed substantially of conductive material (*e.g.*, metal). The beam **204** can be supported by an anchor **206** and a base **207,** which may be integrated with the beam and may serve to connect the beam to an underlying support structure, such as a substrate **208.** The contact **202** may also be supported by the substrate **208.** The switch structure **200** may also include an electrode **210** configured to actuate the beam **204.**

A variety of physical and/or design parameters may affect the stresses in the anchor **206.** The switch structure **200** may be characterized, for example, by a beam length *L_{B},* a beam width *w_{B}*, a beam thickness *t_{B}*, a contact length *L_{C}*, a contact width *w_{C}*, a contact thickness *t_{C}*, a beam-contact separation distance (in the absence of external forces) *d_{BC}*, a beam-electrode overlap length *L_{E}* (measured from the end **205** of the beam **204**), an electrode width *w_{E}*, a beam-electrode separation distance (in the absence of external forces) *d_{BE}*, a beam material or materials (and the corresponding material properties), and a maximum voltage difference *Vₘₐₓ* between the beam and the electrode **210.** By appropriately selecting values for these parameters (in conjunction with the selection of the material of the beam **204** and the expected operational temperatures), the applicants have found that switch structures can be produced for which stresses in the area of the anchor **206** are sufficiently low to enable operational lifetimes for the switch structure **200** of upwards of one or even 20 years.

In some examples, the thickness *t_{B}* of the beam **204** can be at least 1 µm. A thickness *t_{B}* of about 1 µm or more may limit subsequent deformation of the beam due to subsequent processing at elevated temperatures. The length *L_{B}* of the beam **204** can be at least about 20 µm. The contact **202** can be disposed so as to oppose the beam **204** over an area defined by an overlap length *L₀* that is within 20 percent of a free end **205** of the beam. The electrode **210** may be disposed within 50 percent of the free end **205** of the beam **204,** and in some embodiments within 20-30 percent of the free end.

The beam **204** can have a length *L_{B}* that is less than about 200 times greater than the thickness *t_{B}* and is also less than about 1000 times the separation distance *d_{BC}* between the beam and the associated contact **202.** Where the beam **204** has a larger aspect ratio and/or is separated from the contact **202** by a smaller distance, the stress induced in the beam when deformed into the contacting position may be relatively low. However, as the length of the beam **204** is increased, the number of beams that can be placed in a given area will decrease. Further, as the separation distance *d_{BC}* is reduced, failure mechanisms other than creep-related deformation may become significant. For example, as the beam **204** and contact **202** approach one another, the attractive force therebetween increases for a given voltage difference, and this attractive force could become large enough to cause the beam to unintentionally assume the contacting position (*e.g*., even in the absence of a voltage at the electrode **210**). Also, the area between the beam **204** and the contact **202** may be more likely to experience electrical breakdown due to, for example, field emission.

By configuring the beam **104, 204** so as to avoid significant creep during use, the separation distance *d_{BC}* between the beam and the contact **102, 202** can be maintained fairly constant, say, within 20 percent of its initial value, for a time in use of up to 1 year and in some cases upwards of 20 years (a requirement for some applications). In other words, for each instance in which the beam **104, 204** is urged from the non-contacting position (in which the beam is separated from the contact **102, 202** by a distance *d_{BC}*) and toward the contacting position by an applied force and then the applied force is removed, the beam will substantially return to the non-contacting position such that the beam is separated from the contact by the distance *d_{BC}*, where the value of *d_{BC}* varies by less than 20 percent.

By appropriately selecting values for the various design parameters of the switch structure **200** (in conjunction with the selection of the material of the beam **204** and the expected operational temperatures), the applicants have found that switch structures can be produced for which stresses in the area of the anchor 206 are sufficiently low to enable operational lifetimes (*e.g*., a change in the separation distance between the beam **204** and contact **202** of less than 20 percent) for the switch structure **200** of upwards of one or even 20 years. The table below provides several combinations of parameter values, operational temperatures, and beam materials for which the applicants have observed acceptable performance.

| **parameter** | **Au beam** | **Ni-12 atomic % W beam** |
|---|---|---|
| operational lifetime (years) | 20 | 20 |
| operational temperature (°C) | 80 | 200 |
| *L_{B}* (µm) | 190 | 95 |
| *t_{B}* (µm) | 7 | 3 |
| *t_{C}* (µm) | 0.3 | 0.3 |
| *d_{BC}* (µm) | 0.4 | 1 |
| *L_{E}*/ *L_{B}* | 0.2 | 0.2 |
| *Vₘₐₓ* (V) | 21 | 120 |

The process temperatures associated with the production of the above described switch structure **100** formed substantially of metallic material are moderate, usually less than 450 °C. This is in contrast to the temperatures required to form a conductor from silicon, which, when employing a conventional doping procedure, are usually greater than 900 °C. The lower processing temperatures associated with the switch structure **100** may facilitate the integration of the switch structure with temperature-sensitive components, such as, for example, MOSFETs.

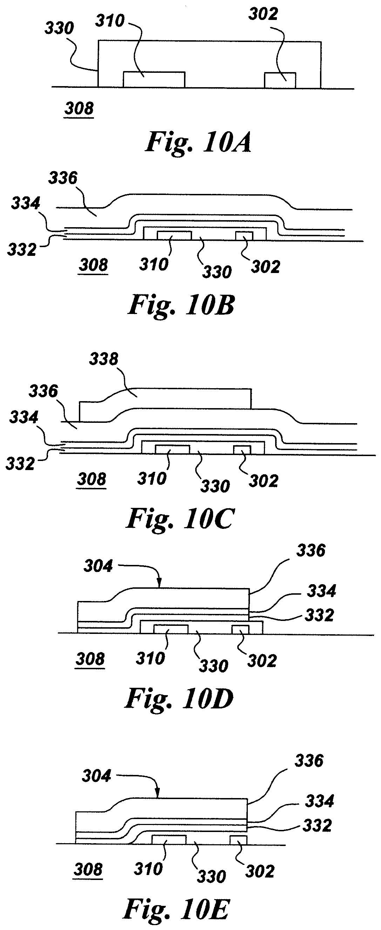

As mentioned above, switch structures as described above, such as the switch structure **100** of Fig. 1, can be fabricated on substrates using conventional microfabrication techniques. For example, referring to Figs. 10A-E, therein is shown a schematic representation of a fabrication process for producing a switch structure configured in accordance with an example. First, a substrate **308** can be provided with an electrode **310** and a contact **302** disposed thereon. Silicon dioxide **330** can then be deposited, for example, by vapor deposition, and patterned so as to encapsulate the electrode **310** and contact **302** (Fig. 10A). A thin adhesion layer **332** (*e.g*., titanium), a seed layer **334** (*e.g.*, gold), and a metal layer **336** (*e.g.*, Ni-4 atomic percent W) can then be deposited via electroplating (Fig. 10B). Photoresist **338** could then be applied and patterned using conventional photolithography (Fig. 10C), after which the metal, seed, and adhesion layers **336, 334, 332** could be etched to form a beam **304** and the photoresist subsequently removed (Fig. 10D). Finally, the silicon dioxide **330** supporting the beam **304** and encapsulating the electrode **310** and contact **302** could be removed (Fig. 10E). Thereafter, the beam **304** may also be enclosed by a protective cap, for example, at a temperature of about 300-450 °C.

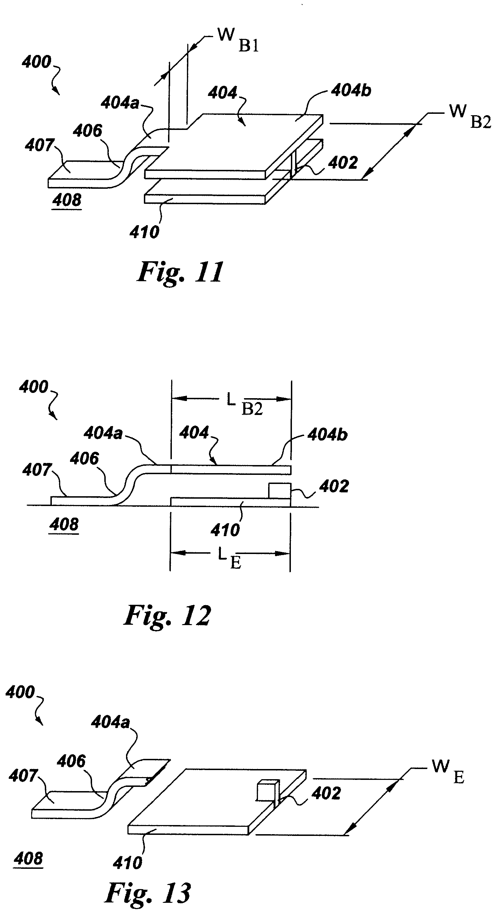

Referring to Figs. 11-13, therein are shown several views of a switch structure **400** configured in accordance with an embodiment of the present invention. The switch structure includes a contact **402** and a conductive element, such as a cantilevered beam **404,** formed substantially of conductive material (*e.g*., metal). The beam **404** is supported by an anchor **406** and a base **407,** which may be integrated with the beam and may serve to connect the beam to an underlying support structure, such as a substrate **408.** The switch structure **400** may also include an electrode **310** configured to actuate the beam **404.** The beam **404** includes a first beam portion **404a** having a width *w_{B1}* and a second beam portion **404b** having a width *w_{B2} > w_{B1}*. The electrode **410** can have a width *w_{E}*, which width may be roughly equal to *w_{B2}.* In this way, the actuating force provided by the electrode **410** can be modulated by modulating the corresponding widths of the second beam portion **404b** and the electrode. The second beam portion **404b** may also have a length *L_{B2}* that is roughly equal to the length *L_{E}* of the electrode **410.**

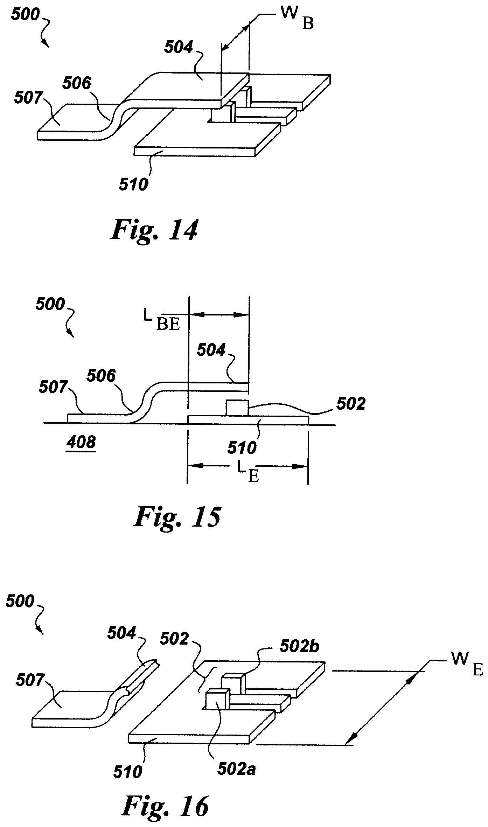

Referring to Figs. 14 and 15, therein are shown several views of a switch structure **500** configured in accordance with another example, which is not an embodiment of the present invention. The switch structure can include a contact **502** and a cantilevered beam **504** supported by an anchor **506** and a base **507.** The switch structure **500** may also include an electrode **510** configured to actuate the beam **504.** The beam **504** can have a width *w_{B}*, and the electrode **510** can have a width *w_{E}* that may be different from the width of the beam. Where *w_{E}* > *w_{B}* the electrostatic force produced by the electrode **510** and acting on the beam **504** may cause efficient actuation of the beam, possibly lowering the energy required to actuate the beam. The contact **502** may include several discrete contact structures **502a, 502b,** and the beam **504** may provide electrical current to each contact structure in parallel or from one to the other in series.

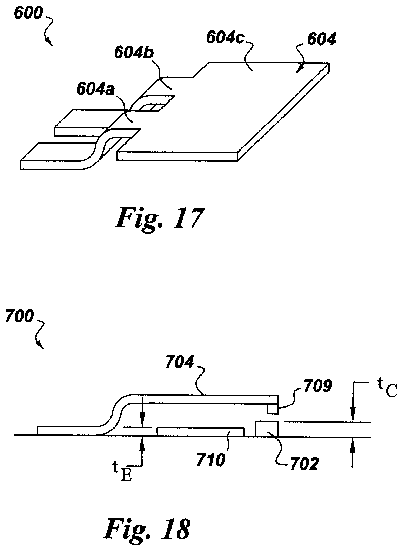

Referring to Fig. 17, in some embodiments of the present invention, a switch structure **600** may include a conductive element **604** that has multiple first cantilever portions **604a, 604b** connected to a common second beam portion **604c.** Referring to Fig. 18, a switch structure **700** may include an opposing contact **702** and beam **704.** The beam **704** may include a protrusion **709** configured to make contact with the contact **702** as the beam is actuated. Such configurations of the beam **704** may facilitate a contact **702** that has a thickness *t_{C}* about equal to the thickness *t_{E}* of an associated electrode **710.**
embodiments may include a beam that is substantially formed of multiple layers of metallic material, with each (or most) of the layers being configured to inhibit time-deformation. It is, therefore, to be understood that the invention is intended to cover all such modifications and changes as fall within the scope of the appended claims.

## Claims

1. A micro-electromechanical device comprising:
a substrate (408); a contact (402) disposed on said substrate (408); and a conductive element disposed on said substrate including an anchor (406) extending from said substrate (408) and a beam (404) having an end coupled to said anchor (406) so as to be cantilevered therefrom and composed substantially of metallic material so that the time-dependent plastic deformation of the conductive element is determined by the time-dependent plastic deformation of constituent metallic material of the conductive element, said conductive element being configured to be deformable between a first position in which said conductive element is separated from said contact (402) by a separation distance and a second position in which said conductive element contacts said contact (402) and stores mechanical energy,
**characterised in that** appropriate material and dimensions of said conductive element have been selected such that, subsequent to being deformed into the second position at a temperature between about room temperature and about half of a melting temperature of said metallic material for a cumulative time of at least 10⁷ seconds, the separation distance in the absence of external forces varies by less than 20 percent over the cumulative time;
wherein said metallic material includes an alloy of at least 65 atomic percent nickel and at least 1 atomic percent tungsten; and
the beam (404) includes a first beam portion (404a) coupled to the anchor (406) having a width *w_{B1}* and a second beam portion (404b) having a width *w_{B2}*, where w_{B2} is greater than *w_{B1}.*

2. The micro-electromechanical device of claim 1, further comprising an electrode (410) on the substrate (408), the electrode (410) being configured to establish an electrostatic force configured to urge the conductive element toward the second position wherein the width (w_{E}) of the electrode (410) is greater than the width (w_{B2}) of the beam (404).

3. The micro-electromechanical device of claim 1 or claim 2, wherein said conductive element (404) establishes electrical communication with said contact (402) when in the second position.

4. The micro-electromechanical device of any preceding claim, wherein said conductive element is configured to store energy during deformation sufficient to cause said conductive element to substantially assume the first position in the absence of external forces.

5. The micro-electromechanical device of any preceding claim, wherein said contact (402) and said conductive element are part of a microelectromechanical device or a nanoelectromechanical device.

6. The micro-electromechanical device of any preceding claim, wherein said beam (404) has a length (L_{B2}) and a thickness, and wherein the length is less than about 200 times greater than the thickness and is less than about 1000 times the separation distance.

7. A method of fabricating a micro-electromechanical device, the method comprising:
providing a substrate ((408);
forming a contact (402) on the substrate (408); forming a conductive element substantially of metallic material on the substrate so that the time-dependent plastic deformation of the conductive element is determined by the time-dependent plastic deformation of constituent metallic material of the conductive element, the conductive element including an anchor (406) extending from the substrate (408) and a beam (404) having an end coupled to the anchor (406) so as to be cantilevered therefrom, the anchor (406) and beam (404) defining an angle therebetween;
**characterised by** the material and dimensions of the conductive elements having been selected such that deforming the conductive element, at temperature between about room temperature and about half of a melting temperature of the metallic material, between a first position, in which the conductive element is separated from the contact (402) by a separation distance, and a second position, in which the conductive element contacts the contact (402) and stores energy, the conductive element occupying the second position for a cumulative time of at least 10⁷ seconds;
subsequent to said deforming the conductive element and, removal of the external forces from the conductive element, the conductive element returns to the first position and the angle varies by less than 0.1 percent;
wherein said forming the conductive element substantially of metallic material includes forming a conductive element substantially of an alloy of at least 65 atomic percent nickel and at least 1 atomic percent tungsten;
wherein the beam (404) includes a first beam portion (404a) coupled to the anchor (406) having a width *w_{B1}* and a second beam portion (404b) having a width *w_{B2}*, where *w_{B2}* is greater than *w_{B1}.*

8. The method of claim 7, further comprising forming an electrode (410) on the substrate (408), the electrode (410) being configured to establish an electrostatic force configured to urge the conductive element toward the second position wherein the width (w_{E}) of the electrode (410) is greater than the width (w_{B2}) of the beam (404).

9. The method of claim 7 or claim 8, wherein said forming a conductive element on the substrate (408) includes forming a conductive element having a surface area-to-volume ratio that is greater than or equal to 10³ m⁻¹.

10. The method of any of claims 7 to 9, further comprising enclosing the contact (402) and conductive element between the substrate (408) and a protective cap.

## Patentansprüche

1. Mikroelektromechanische Vorrichtung, die Folgendes aufweist:
ein Substrat (408);
einen Kontakt (402), der auf dem Substrat (408) angeordnet ist; und
ein leitendes Element, das auf dem Substrat angeordnet ist, und das einen Anker (406), der sich von dem Substrat (408) erstreckt, und einen Balken (404) aufweist, der ein Ende aufweist, das mit dem Anker (406) derart verbunden ist, dass er freiliegend davon ist, und im Wesentlichen aus einem metallischen Material besteht, derart dass die zeitabhängige plastische Verformung des leitenden Elements von der zeitabhängigen plastischen Verformung des daraus bestehenden metallischen Materials des leitenden Elements bestimmt ist, wobei das leitenden Element dazu ausgelegt ist, zwischen einer ersten Position, in der das leitende Element von dem Kontakt (402) um einen Trennungsabstand getrennt ist, und einer zweiten Position, in der das leitende Element mit dem Kontakt (402) in Verbindung ist, verformbar zu sein, und mechanische Energie spart,
**dadurch gekennzeichnet, dass** das geeignet Materialien und geeignete Abmessungen des leitenden Elements derart ausgewählt werden, dass nach Verformung in die zweite Position bei einer Temperatur ungefähr zwischen Raumtemperatur und der halben Schmelztemperatur des metallischen Materials über eine kumulative Zeit von mindestens 10⁷ Sekunden, der Trennungsabstand bei Abwesenheit von äußeren Kräften um weniger als 20 Prozent von der kumulativen Zeit variiert;
wobei das metallische Material eine Legierung aus mindestens 65 Atomprozent Nickel und mindestens 1 Atomprozent Wolfram aufweist; und
der Balken (404) einen ersten Balkenabschnitt (404a), der mit dem Anker (406) verbunden ist und eine Breite *w_{B1}* aufweist, und einen zweiten Balkenabschnitt (404b) mit einer Breite *w_{B2}*, wobei *w_{B2}* größer als *w_{B1}* ist, aufweist.

2. Mikroelektromechanische Vorrichtung nach Anspruch 1, die weiter eine Elektrode (410) auf dem Substrat (408) aufweist, wobei die Elektrode (410) dazu ausgelegt ist, eine elektrostatische Kraft zu erzeugen, die dazu ausgelegt ist, das leitende Element zu der zweiten Position hin zu bewegen, wobei die Breite (*w_{E}*) der Elektrode (410) größer als die Breite (*w_{B2}*) des Balkens (404) ist.

3. Mikroelektromechanische Vorrichtung nach Anspruch 1 oder Anspruch 2, wobei das leitende Element (404) in der zweiten Position eine elektrische Verbindung mit dem Kontakt (402) herstellt.

4. Mikroelektromechanische Vorrichtung nach einem der vorstehenden Ansprüche, wobei das leitende Element dazu ausgelegt ist, Energie während der Verformung zu speichern, die ausreichend ist, um das leitende Element zu veranlassen, im Wesentlichen die erste Position bei Abwesenheit von äußeren Kräften einzunehmen.

5. Mikroelektromechanische Vorrichtung nach einem der vorstehenden Ansprüche, wobei der Kontakt (402) und das leitende Element Teil einer mikroelektromechanischen Vorrichtung oder einer nanoelektromechanischen Vorrichtung sind.

6. Mikroelektromechanische Vorrichtung nach einem der vorstehenden Ansprüche, wobei der Balken (404) eine Länge (*L_{B2}*) und eine Dicke aufweist, wobei die Länge weniger als ungefähr 200-mal größer als die Dicke ist, und weniger als ungefähr 1000-mal der Trennungsabstand ist.

7. Verfahren zum Herstellen einer mikroelektromechanischen Vorrichtung, wobei das Verfahren Folgendes aufweist:
Vorsehen eines Substrats (408);
Bilden eines Kontakts (402) auf dem Substrat (408);
Bilden eines leitenden Elements, im Wesentlichen aus einem metallischen Material, auf dem Substrat, derart dass die zeitabhängige plastische Verformung des leitenden Elements von der zeitabhängigen plastischen Verformung des daraus bestehenden metallischen Materials des leitenden Elements bestimmt ist, wobei das leitenden Element einen Anker (406), der sich von dem Substrat (408) erstreckt, und einen Balken (404) aufweist, der ein Ende aufweist, das mit dem Anker (406) derart verbunden ist, dass er freiliegend davon ist, wobei der Anker (406) und der Balken (404) einen Winkel dazwischen definieren;
**dadurch gekennzeichnet, dass** das Material und die Abmessungen des leitenden Elements derart ausgewählt werden, dass das leitende Element bei einer Temperatur ungefähr zwischen Raumtemperatur und halber Schmelztemperatur des metallischen Materials zwischen einer ersten Position, in der das leitende Element um einen Trennungsabstand von dem Kontakt (402) getrennt ist, und einer zweiten Position, in der das leitende Element mit dem Kontakt (402) in Verbringung steht, verformt wird und Energie speichert, wobei das leitende Element die zweite Position über eine kumulative Zeit von mindestens 10⁷ Sekunden einnimmt;
wobei nach der Verformung des leitenden Elements und Entfernung äußerer Kräfte von dem leitenden Element, das leitende Element in die erste Position zurückkehrt und der Winkel um weniger als 0,1 Prozent variiert;
wobei das Bilden des leitenden Elements aus im Wesentlichen metallischen Material das Bilden eines leitenden Elements im Wesentlichen aus einer Legierung aus mindestens 65 Atomprozent Nickel und mindestens 1 Atomprozent Wolfram aufweist;
wobei der Balken (404) einen ersten Balkenabschnitt (404a), der mit dem Anker (406) verbunden ist und eine Breite *w_{B1}* aufweist, und einen zweiten Balkenabschnitt (404b) mit einer Breite *w_{B2}*, wobei *w_{B2}* größer als *w_{B1}* ist, aufweist.

8. Verfahren nach Anspruch 7, das weiter das Bilden einer Elektrode (410) auf dem Substrat (408) aufweist, wobei die Elektrode (410) dazu ausgelegt ist, eine elektrostatische Kraft zu erzeugen, die dazu ausgelegt ist, das leitende Element zu der zweiten Position hin zu bewegen, wobei die Breite (*w_{E}*) der Elektrode (410) größer als die Breite (*w_{B2}*) des Balkens (404) ist.

9. Verfahren nach Anspruch 7 oder Anspruch 8, wobei das Bilden eines leitenden Elements auf dem Substrat (408) Bilden eines leitenden Elements mit einem Verhältnis von Fläche zu Volumen, das größer oder gleich 10³ m⁻¹ ist, aufweist.

10. Verfahren nach einem der Ansprüche 7 bis 9, das weiter das Umschließen des Kontakts (402) und des leitenden Elements zwischen dem Substrat (408) und einer Schutzkappe aufweist.

## Revendications

1. Dispositif micro-électromécanique comprenant :
un substrat (408) ;
un contact (402) disposé sur ledit substrat (408) ; et
un élément conducteur disposé sur ledit substrat comprenant une ancre (406) s'étendant dudit substrat (408) et une poutre (404) ayant une extrémité couplée à ladite ancre (406) de manière à être en porte-à-faux vis-à-vis de celle-ci et composée sensiblement d'un matériau métallique de sorte que la déformation plastique en fonction du temps de l'élément conducteur soit déterminée par la déformation plastique en fonction du temps du matériau métallique constituant de l'élément conducteur, ledit élément conducteur étant configuré pour être déformable entre une première position dans laquelle ledit élément conducteur est séparé dudit contact (402) d'une distance de séparation et une seconde position dans laquelle ledit élément conducteur vient en contact avec ledit contact (402) et stocke de l'énergie mécanique,
**caractérisé en ce que** le matériau et les dimensions appropriés dudit élément conducteur ont été choisis en sorte que, après déformation dans la seconde position à une température entre à peu près la température ambiante et à peu près la moitié d'une température de fusion dudit matériau métallique pendant une période cumulée d'au moins 10⁷ secondes, la distance de séparation en l'absence de forces externes varie de moins de 20 pour cent sur la période cumulée ;
dans lequel ledit matériau métallique comprend un alliage d'au moins 65 pour cent atomique de nickel et d'au moins 1 pour cent atomique de tungstène ; et
la poutre (404) comprend une première partie de poutre (404a) couplée à l'ancre (406) ayant une largeur w_{B1} et une seconde partie de poutre (404b) ayant une largeur w_{B2}, où w_{B2} est supérieure à w_{B1}.

2. Dispositif micro-électromécanique selon la revendication 1, comprenant en outre une électrode (410) sur le substrat (408), l'électrode (410) étant configurée pour établir une force électrostatique configurée pour presser l'élément conducteur vers la seconde position, dans lequel la largeur (w_{E}) de l'électrode (410) est supérieure à la largeur (w_{B2}) de la poutre (404).

3. Dispositif micro-électromécanique selon la revendication 1 ou la revendication 2, dans lequel ledit élément conducteur (404) établit une communication électrique avec ledit contact (402) lorsqu'il se trouve dans la seconde position.

4. Dispositif micro-électromécanique selon l'une quelconque des revendications précédentes, dans lequel ledit élément conducteur est configuré pour stocker de l'énergie au cours d'une déformation suffisante pour amener ledit élément conducteur à assumer sensiblement la première position en l'absence de forces externes.

5. Dispositif micro-électromécanique selon l'une quelconque des revendications précédentes, dans lequel ledit contact (402) et ledit élément conducteur font partie d'un dispositif micro-électromécanique ou d'un dispositif nano-électromécanique.

6. Dispositif micro-électromécanique selon l'une quelconque des revendications précédentes, dans lequel ladite poutre (404) a une longueur (L_{B2}) et une épaisseur et dans lequel la longueur est de moins d'environ 200 fois supérieure à l'épaisseur et est de moins d'environ 1 000 fois la distance de séparation.

7. Procédé de fabrication d'un dispositif micro-électromécanique, le procédé comprenant :
la fourniture d'un substrat (408) ;
la formation d'un contact (402) sur le substrat (408) ;
la formation d'un élément conducteur sensiblement constitué d'un matériau métallique sur le substrat de sorte que la déformation plastique en fonction du temps de l'élément conducteur soit déterminée par la déformation plastique en fonction du temps du matériau métallique constituant de l'élément conducteur, l'élément conducteur comprenant une ancre (406) s'étendant du substrat (408) et une poutre (404) ayant une extrémité couplée à l'ancre (406) de manière à être en porte-à-faux vis-à-vis de celle-ci, l'ancre (406) et la poutre (404) définissant un angle entre elles ;
**caractérisé en ce que** le matériau et les dimensions des éléments conducteurs ont été choisis de sorte que la déformation de l'élément conducteur à une température entre à peu près la température ambiante et à peu près la moitié d'une température de fusion du matériau métallique entre une première position, dans laquelle l'élément conducteur est séparé du contact (402) par une distance de séparation, et une seconde position, dans laquelle l'élément conducteur vient en contact avec le contact (402) et stocke de l'énergie, l'élément conducteur occupant la seconde position pendant une période cumulée d'au moins 10⁷ secondes ;
après ladite déformation de l'élément conducteur et le retrait des forces externes de l'élément conducteur, l'élément conducteur retourne à la première position et l'angle varie de moins de 0,1 pour cent ;
dans lequel ladite formation de l'élément conducteur sensiblement dans un matériau métallique comprend la formation d'un élément conducteur sensiblement dans un alliage d'au moins 65 pour cent atomique de nickel et d'au moins 1 pour cent atomique de tungstène ;
dans lequel la poutre (404) comprend une première partie de poutre (404a) couplée à l'ancre (406) ayant une largeur w_{B1} et une seconde partie de poutre (404b) ayant une largeur w_{B2}, où w_{B2} est supérieure à w_{B1}.

8. Procédé selon la revendication 7, comprenant en outre la formation d'une électrode (410) sur le substrat (408), l'électrode (410) étant configurée pour établir une force électrostatique configurée pour presser l'élément conducteur vers la seconde position, dans lequel la largeur (w_{E}) de l'électrode (410) est supérieure à la largeur (w_{B2}) de la poutre (404).

9. Procédé selon la revendication 7 ou la revendication 8, dans lequel ladite formation d'un élément conducteur sur le substrat (408) comprend la formation d'un élément conducteur ayant un rapport de la surface au volume qui est supérieur ou égal à 10³ m⁻¹.

10. Procédé selon l'une quelconque des revendications 7 à 9, comprenant en outre l'enserrement du contact (402) et de l'élément conducteur entre le substrat (408) et un chapeau protecteur.
